# EUROPEAN PATENT APPLICATION

(11) **EP 4 339 992 A1**
(43) Date of publication of application: **20.03.2024**
(21) Application number: 23196850.4
(22) Date of filing: 12.09.2023
(51) Int. Cl.: H01J 37/02, H01J 37/09

(54) **MESH INTEGRITY CHECK**

(30) Priority: 14.09.2022 DE 102022209644
(71) Applicant: Carl Zeiss SMT GmbH, 73447 Oberkochen (DE)
(72) Inventor: LÄMMLE, David, 73447 Oberkochen (DE); BUDACH, Michael, 73447 Oberkochen (DE); GÜNTNER, Jan, 73447 Oberkochen (DE); SCHOTSCH, Frans-Felix, 73447 Oberkochen (DE)
(74) Representative: Bardehle Pagenberg Partnerschaft mbB Patentanwälte Rechtsanwälte

(57) **Abstract**

The present application relates to a method for characterizing a shielding element (C) of a particle beam device (100) for shielding an electric field between a sample position and a particle beam source (101). The method comprises positioning a means for characterizing (S1, S2, S3) the shielding element on a side of the shielding element which is facing the sample position.

## Description

The present application claims the priority of the German patent application DE 10 2022 209 644.4 with the title "Maschenintegritatscheck", which was filed at the German Patent and Trademark Office on September 14, 2022. In this respect, reference is made to the application DE 10 2022 209 644.4, the content of which is hereby incorporated into this application.

### 1. Technical field

The present invention relates to a method for characterizing a shielding element of a particle beam device, to means for characterizing the shielding element, to a particle beam device and to a corresponding computer program.

### 2. Prior art

Apparatuses are known in which a particle beam from a particle beam source is directed at a sample. By providing the particle beam, for example, the sample can be observed in the process (e.g. with an electron microscope). However, the sample can also be irradiated with the particle beam during a particle beam-induced process (e.g. particle beam-induced etching and/or deposition).

It is known here to arrange a shielding element between the sample and the particle beam source. The shielding element can be used to spatially limit an electric field which originates from the sample, for example. For this purpose, the shielding element is usually arranged at a distance (as close as possible) from the sample, so that the influence of the electric field on the incident particle beam can be kept low. In particular, the shielding element can be used if the particle beam has charged particles (e.g. electrons and/or ions), which can interact with an electric field. This interaction can be spatially limited by the shielding element, with the result that, for example, an uncontrolled beam deflection of the particle beam can be minimized.

In DE102020124307A1, a device for analysing and/or processing a sample with a particle beam is described. The device has a shielding element for shielding an electric field generated by charges accumulated on the sample, wherein the shielding element has a through opening for the particle beam to pass through to the sample.

However, the shielding element may not always have a suitable target state. Deviations from the target state can be caused, for example, by regular operation, during the assembly and/or maintenance of the device. For example, the shielding element may have defects and/or be deformed in such a way that the sample can be damaged by the shielding element. In order to avoid this, it has, for example, been a known procedure so far to observe the shielding element via the particle beam in order to infer a deviation. However, not all regions of the shielding element are accessible with the particle beam, meaning that the shielding element cannot always be accurately analysed.

Previous approaches can therefore only partially prevent damage to the sample by the shielding element.

It is an object of the present invention therefore to alleviate this problem.

### 3. Summary of the invention

This object is at least partly achieved by the various aspects of the invention.

A first aspect relates to a method for characterizing a shielding element of a particle beam device for shielding an electric field between a sample position and a particle beam source. The method comprises positioning a means for characterizing the shielding element on a side of the shielding element which is facing the sample position.

The invention can thus make it possible for the side of the shielding element which is facing the sample to be made accessible for the characterizing of the shielding element. The side of the shielding element facing the sample can also be called the sample side. The side of the shielding element which is facing the particle beam source can also be referred to herein as the incidence side of the shielding element, since a particle beam from the particle beam source can be incident on this side.

The method can thereby enable an advantageous characterizing of the shielding element. In previous approaches, for example, at best the surface of the shielding element on the incidence side has been able to be characterized (e.g. by means of an image recording with the particle beam). However, deviations (e.g. defects) on the incidence side of the shielding element do not always cause a damaging effect on the sample during operation. For example, it is conceivable that a defect on the incidence side (e.g. a particle disposed thereon) may not be able to influence the sample mechanically, since the defect is not arranged between the sample and the shielding element but between the shielding element and the particle beam source. Thus, a characterization on the incidence side cannot always provide all the information needed to determine whether the shielding element might damage the sample during operation. In the case of a characterization of only the incidence side, a property of the sample side can at most be ascertained by means of a reconstruction. However, the shielding element may also comprise a partial region or be constructed in its entirety in such a way that the sample side cannot be reconstructed. In this case, characterizing the incidence side of the shielding element would be done "blindly" with respect to a deviation on the sample side.

However, it may in fact be deviations on the surface of the sample side of the shielding element that are responsible for damage to the sample, since it can interact directly with the surface of the sample. Firstly, the surface of the sample side of the shielding element is directly facing the surface of the sample, so that a direct interaction takes place. Secondly, the shielding element is usually arranged in the immediate proximity of the sample during the operation of the particle beam device. This allows the influence of the electric field, which for example originates from the sample, on the particle beam to be spatially limited. However, due to the immediate proximity, deviations on the sample side of the shielding element can damage or impair the sample much more easily. For example, a deviation on the sample side of the shielding element may comprise a defective site which may scratch the surface of the sample, or a defective site of the shielding element may also introduce unwanted particles on the surface of the sample.

The invention can enable a direct and/or complete characterization of the sample side, because, since the means for characterizing is positioned on the sample side, it has unimpeded access to the surface of the shielding element on the sample side. Reliable information about the shielding element on the sample side can thus be obtained.

For example, the means for characterizing can be positioned statically in the particle beam device. The means for characterizing can be, for example, fastened (or have been attached) in the particle beam device in such a way that a characterization of the sample side of the shielding element is possible (e.g. without further shifting of the means for characterizing).

For example, positioning may comprise the initial introduction of the means for characterizing into the particle beam device. Subsequently, the means for characterizing can be further positioned in the particle beam device so that it is at a position which is on the sample side of the shielding element.

Positioning can be carried out e.g. via a means for positioning (e.g. a positioner), on which the means for characterizing rests and/or is fastened. For example, the means for positioning may comprise a sample holder and/or a stage which is spatially displaceable within the particle beam device. It is also possible for the means for characterizing to be firmly integrated into a sample holder, for example.

In one example, the method comprises characterizing the side of the shielding element, which is facing the sample position, at least in part with the means for characterizing. The surface of the shielding element on the sample side can thus be characterized in a suitable manner by way of the positioning of the means for characterizing on the sample side. Positioning and/or characterizing can take place, for example, as part of a technical assessment, maintenance measure, technical service, etc. of the particle beam device.

In one example, characterizing comprises capturing a topology of the shielding element, wherein the topology is captured on the side of the shielding element which is facing the sample position. For example, the topology may comprise a height profile of the shielding element on the sample side. The height profile may comprise, for example, at least a first height value for a first (spatial) coordinate and a second height value for a second (spatial) coordinate of the shielding element on the sample side. Further, the height profile may accordingly comprise at least three height values, at least four height values, at least five height values and/or at least ten height values. In other examples, instead of a height profile, merely a single height value can also be recorded as a topology (e.g. a maximum or minimum).

The capturing of the topology may also comprise, for example, an interpolation and/or extrapolation of the captured height profile.

For example, capturing the topology can also comprise capturing a reference plane, which can serve as a reference plane for the topology.

In one example, characterizing comprises determining an anomaly in the topology, at least in part on the basis of a target state of the topology and the captured topology. For example, the captured topology can be compared with the target state of the topology. For example, the target state can comprise a characteristic topology (e.g. a characteristic height profile) whose deviation from the captured topology is determined. For example, the course of the captured height profile can be compared with the course of the target state of the height profile in order to determine whether a defect has changed the target course as an anomaly. For example, a defect can cause an uncharacteristic (local) height and/or an uncharacteristic (local) depression in the topology and make itself known thus. Furthermore, the target state may also comprise a target value of the characteristic topology (e.g. a target value of a maximum and/or a minimum of the topology, a target value of a height of the characteristic topology with respect to a reference plane, etc.).

In one example, characterizing comprises determining whether the shielding element extends into the sample position. The sample position may comprise a position of a sample (or its surface) in the particle beam device, wherein the sample position is adopted, for example, during processing and/or observation of the sample. The sample position may correspond here to a distance between the surface of the sample in the sample position and the shielding element. Extending into the sample position may comprise that the shielding element extends into a surface of the sample in the sample position or into a plane which is spanned by the surface of the sample in the sample position (or that it would extend if a sample were inserted). If it is determined that the shielding element extends into the sample position, contact of the shielding element with a sample in the sample position can be assumed. The determination of whether the shielding element extends into the sample position can be at least in part based on the captured topology. For example, the sample position (or the distance of the surface of the sample in the sample position from the shielding element) can be compared with the course of the topology.

The method can thus be used to determine whether the shielding element contacts (or would contact) a sample in the sample position, based at least in part on the captured topology.

In one example, the means for characterizing comprises a sensor for measuring the topology, and the capturing of the topology is based at least in part on a measurement of the topology using the sensor. The sensor can be communicatively coupled here to the particle beam device. The sensor can be set, for example, via the device, or the data (e.g. the measurement results of the topology) can be received via the particle beam device. For example, the particle beam device can evaluate the measurement results (e.g. via an evaluation unit). In addition, the sensor can also be coupled to an external device (e.g. via a cable and/or wirelessly). For example, it is conceivable that for the method a chamber of the particle beam device is opened to allow access of the means for characterizing to the sample side of the shielding element. The sensor may then be positioned within the particle beam device, wherein the cable thereof may be connected to the external device via the open chamber. The external device can comprise, for example, an evaluation unit, a computer, etc.

In one example, the sensor comprises a confocal sensor, and the measurement of the topology is based at least in part on a confocal measurement principle.

In one example, the sensor comprises an interferometric sensor, and the measurement of the topology is at least in part based on an interferometric measurement principle.

In order to perform a measurement with the sensor (e.g. for a measurement according to the confocal measurement principle and/or according to the interferometric measurement principle), it may be necessary to spatially displace the sensor. Therefore, the method may comprise attaching the means for characterizing (e.g. the sensor) on a sample and/or a sample holder. Thus, the means for characterizing can be positioned in a suitable manner for measuring the topology. For example, it may be necessary for a measurement according to the confocal measurement principle that the confocal sensor measures the surface of the shielding element on the sample side point by point (e.g. at a defined measurement distance). A point-by-point scanning of the surface can be made possible by means of a corresponding positioning of the means for characterizing, which can be adjusted and controlled with respect to the measurement process. For example, the positioning of the means for characterizing can be controlled during the measurement by the particle beam device and/or the external device if the particle beam device and/or the external device are communicatively coupled with the sensor. Furthermore, it is also conceivable that for a measurement the means for characterizing is positioned manually (e.g. via an operator).

In one example, the means for characterizing can be positioned at a predetermined distance from the shielding element; wherein the predetermined distance corresponds to a target distance between a sample and the shielding element. The target distance can correspond in this case to a distance of the surface of the sample from a surface of the shielding element on the sample side. The target distance can then correspond to a distance between the sample at a specific sample position and the shielding element. In this case, the means for characterizing can thus be subjected to an effect that can occur at the target distance of the sample from the shielding element. Via the means for characterizing, it is thus possible, for example, to directly "test" whether the shielding element extends into the sample position (as described herein).

In one example, the method further includes detecting the presence or absence of a contact between the means for characterizing and the shielding element. Detecting can, for example, be understood to also mean capturing the topology, since in the presence of a contact, at least one topology stage of the shielding element contacts the means for characterizing.

In one example, detection comprises detecting a contact signal that is caused when the contact is present.

In one example, the method comprises an approach of the means for characterizing in the direction of the shielding element to position the means for characterizing at the predetermined distance from the shielding element. If a contact signal is detected during the approach, the further approach in the direction of the shielding element can be aborted, e.g. in order to prevent damage to the shielding element.

In one example, the means for characterizing is mounted movably in a vertical direction (e.g. via a spring element). The approach in the direction of the shielding element can be effected along the vertical direction (relative to the means for characterizing). If a contact occurs during the approach, a movement of the means for characterizing which is opposite to the approach movement can take place. Damaging effects on the shielding element and/or the means for characterizing during the contact can therefore be minimized.

In one example, the means for characterizing is at least in part electrically conductive, and the detection comprises detecting an electrical current that flows through the means for characterizing and the shielding element in the presence of the contact. The contact signal can be provided here by the particle beam device. For example, it is conceivable that the device is configured to detect a contact of the shielding element with a sample and/or the sample holder. This detection may at least in part be based on the detection of an electrical current flowing through the shielding element and the sample and/or the sample holder during this contact. By providing an at least partially electrically conductive means for characterizing, this functionality can be used to characterize the shielding element (as described herein). The contact signal can, for example, also be communicated from the particle beam device to an external device, which controls, for example, the approach (and also the positioning) of the means for characterizing.

In one example, the method further comprises moving the means for characterizing in a lateral direction which is parallel to the surface of the sample in the sample position. Moving in the lateral direction can be effected, for example, at the predetermined distance. For example, after the approach, the movement can take place in the lateral direction. For example, in the absence of a contact signal at the predetermined distance it can be confirmed whether this is also true in the case of a lateral movement (or after a lateral movement). In addition, during the lateral movement, the contact signal (or its presence or absence) can be recorded in order to draw conclusions about a characteristic of the shielding element (e.g. about the topology of the shielding element).

In one example, the means for characterizing comprises a contact surface which is mounted movably in the lateral direction (e.g. via a spring element). Capturing the topology can further comprise: moving the means for characterizing from a first position to a second position by a predetermined distance (or a predetermined movement distance) in the lateral direction; ascertaining a distance (or a movement distance) of the contact surface caused by moving the means for characterizing in the lateral direction.

The lateral direction in which the contact surface of the means for characterizing is movably mounted may be perpendicular to the vertical direction (described herein) of the means for characterizing. The lateral direction can therefore correspond to the horizontal direction (or horizontal axis) of the means for characterizing.

The movement of the means for characterizing can be carried out, for example, defined via the sample holder on which the means for characterizing can be mounted. In this case, the predetermined movement distance (of the sample holder) can be entered into the particle beam device, which moves the means for characterizing (or the sample holder) accordingly.

In this example, it can be determined whether the laterally movably mounted contact surface concomitantly moves in accordance with the lateral movement of the means for characterizing. This is the case, for example, if the predetermined movement distance of the means for characterizing (substantially) corresponds to the ascertained movement distance of the contact surface. The surface of the shielding element on the sample side can be characterized by comparing the respective movement distances. In other examples, the method may alternatively or additionally comprise that the means for characterizing is moved in the lateral direction and it is tested whether the contact surface moves and/or (fully) moves (or has moved) concomitantly.

In one example, the method furthermore includes: if the contact surface has shifted by the predetermined movement distance, detecting an absence of the contact. In this case it can be inferred that the laterally movably mounted contact surface is not subjected to an effect (e.g. contact) of the shielding element. Accordingly, it can be detected that there is no (unwanted) contact of the shielding element with the means for characterizing.

Furthermore, the method may include: if the contact surface has not shifted by the predetermined movement distance (or, for example, if it has not shifted at all or not significantly), detecting a presence of the contact. In this case it can be inferred that the laterally movably mounted contact surface is subjected to an effect (e.g. contact) of the shielding element. Accordingly, it can be detected that there is an (unwanted) contact of the shielding element with the means for characterizing. Furthermore, it is conceivable that a presence of the contact is detected starting from a threshold value of the deviation between the predetermined movement distance and the ascertained movement distance of the contact surface. For example, the presence of the contact can be detected if the movement distance of the contact surface deviates from the predetermined movement distance by at least 1%, at least 2%, at least 3% and/or at least 5%.

In one example, ascertaining the movement distance comprises: recording a first image of a reference structure of the contact surface in the first position of the means for characterizing; recording a second image of the reference structure of the contact surface in the second position of the means for characterizing; determining a distance between the reference structure in the first image and the reference structure in the second image in order to ascertain the movement distance of the contact surface.

The images can be recorded here via the particle beam of the particle beam device (e.g. the image may comprise a particle beam image, e.g. a scanning force electron image). Furthermore, the images can also be recorded via an optical system of the particle beam device (e.g. the image may comprise an optical image).

The reference structure may comprise here a suitable structure on the surface of the means for characterizing. For example, the reference structure may be mounted on the means for characterizing in a targeted manner for the method. For example, the reference structure may comprise a characteristic structure on the surface of the means for characterizing (e.g. an edge, a surface structure, a particle, etc.).

In one example, the method further includes: detecting a scratch mark on the means for characterizing, which was caused by the movement in the lateral direction.

The scratch mark can be detected e.g. in situ in the particle beam device. Here, for example, a particle beam image and/or a plurality of particle beam images can be recorded with the particle beam device (e.g. one or more scanning force electron images). Furthermore, it is also conceivable that one or more particle beam images are recorded perpendicular to the lateral direction (as described herein). In the presence of a scratch mark, the one or more particle beam images would therefore be (substantially) perpendicular to the scratch mark. If a part of a scratch mark is detected in a particle beam image, one or more particle beam images can then be recorded along the scratch mark in order to completely record the scratch mark. The particle beam images may comprise, for example, a field of view having a length dimension of less than 4 µm, less than 6 µm, less than 10 µm, less than 20 µm and/or less than 100 µm. The length dimension can be understood here to mean a dimension in the x-direction and also in the y-direction.

In a further example, it is conceivable that the scratch mark is detected via an optical system (e.g. with the aid of light or photon beams). The optical system may be comprised in the particle beam device, for example, so that the detection of the scratch mark can here also take place in situ. Furthermore, it is also conceivable that the detection takes place ex-situ outside the device via an optical system. The method may comprise here removing the means for characterizing from the particle beam device after the characterization (as described herein). Subsequently, an analysis of the means for characterizing can take place via the (external) optical system in order to detect the scratch mark.

A second aspect relates to a means for characterizing a shielding element of a particle beam device, wherein the shielding element for shielding an electric field is arranged between a sample position and a particle beam source. The means may comprise: a sensor for capturing a topology of the shielding element and/or a movable, preferably spring-loaded, contact surface for contacting the shielding element. Furthermore, the means for characterizing may be configured to be mounted on a sample holder of the particle beam device.

For example, a cohesive bond with the sample holder can be ensured via the shape of the means for characterizing. In a further example, an underside of the means for characterizing can be intended for a reliable attachment on the sample holder (e.g. via a corresponding roughness, which can reliably support e.g. adhesion with the sample).

Further, for example, the means for characterizing may be configured to be mounted on a sample, which can be mounted on the sample holder of the device.

For example, the sample may comprise a mask blank. The mask blank may comprise, for example, a mask blank for a mask of (micro and/or nano) lithography (e.g. i-line lithography, DUV lithography, EUV lithography, etc.). The particle beam device can be configured, for example, to observe and/or process lithography masks (e.g. for a mask repair).

In one example, the means for characterizing further comprises a base, wherein the contact surface is movably coupled to the base, preferably via a spring element, perpendicular to the contact surface. For example, the base can comprise a frame structure. An underside of the frame structure may be arranged here opposite the contact surface. At least one spring element, which couples the contact surface perpendicularly to the base (or the underside of the base), can be mounted on the underside. For example, the spring element may comprise a spring. In addition, a spring system consisting of two or more springs is also conceivable. Furthermore, the frame structure may comprise a side structure, which is mounted perpendicular to the underside. For example, the side structure can extend from the underside so that the side structure and the underside form a monolithic structure. The side structure may comprise in the region of the contact surface a holding region, which may be formed parallel to the contact surface. The holding region can at least partially (positively) enclose the contact surface in its peripheral region. The holding region can be used to limit a deflection of the contact surface starting from the underside in the perpendicular direction. For example, the spring element may be configured such that a (defined) force is applied in the perpendicular direction via the contact surface against the holding region. Thus, a contact surface defined in one plane can be ensured, which can, however, also yield in the direction of the underside if a perpendicular force is applied. This can be advantageous, for example, in the case of a contact with the shielding element (e.g. during the approach, as described herein), since the shielding element is thus somewhat protected by the yielding of the contact surface.

In one example, the contact surface is movably coupled to the base along a plane of the contact surface, preferably via a spring element. For example, the contact surface can be coupled to the side structure of the base via a spring element. This can ensure a suspension of the contact surface in the plane of the contact surface or perpendicular to the side structure. The contact surface can therefore be mounted movably parallel to the plane of the underside. This may enable the detection of a contact during a lateral movement of the means for characterizing (as described herein). If, for example, the contact surface is held or fixed by a contact with the shielding element, the base of the means for characterizing can continue to move along the plane of the contact surface due to the movable coupling. However, the movement of the contact surface would be (at least in part) impeded. If a contact is present, the movement distance of the base would thus not correspond to the movement distance of the contact surface. A presence or absence of the contact (as described herein) may be inferred in this way.

In one example, the contact surface has a first plane and a second plane with reference to the base; wherein the first plane lies below the second plane; wherein the second plane is dimensioned such that it coincides with a peripheral region of the shielding element. The spatial arrangement of the planes can be referred to the base (e.g. the underside of the base). Accordingly, the lower, first plane may have a greater distance from the shielding element (when used in the method described herein) than the upper, second plane. The two planes allow for a safety margin in the method described herein. For example, when positioning the means for characterizing at the predetermined distance from the shielding element, it is possible to select the predetermined distance with respect to the surface of the first plane. A deviation in the peripheral region of the shielding element is therefore more likely to be detected via the second plane, since the latter is closer to the shielding element than the first plane. In particular, the second plane can prematurely cause contact with the shielding element during an approach (as described herein).

For example, the shielding element may (typically) comprise a holding element in the peripheral region. The holding element may, for example, have a geometrically wider structure than other elements of the shielding element and, for example, act as a connecting element of the shielding element. For example, the holding element may be configured to fix a comparatively thinner mesh structure in the inner region of the shielding element. For example, the holding element may have a topology which preferably extends into the sample position (e.g. in contrast to other elements of the shielding element). For example, the holding element may be shaped such that its surface is closer to a sample position (or sample holder) than is the shielding element. A defect or deviation in the region of the holding element (i.e. in the peripheral region) can therefore affect the sample in the sample position with a greater probability.

In addition, tilting of the shielding element and/or the sample during operation can also be taken into account via the gradation of the second and first planes. In case of tilting, contact of the shielding element with the sample in the peripheral region of the shielding element would be expected, for example. Owing to the gradation, the upper, second plane can therefore act as a safety margin. If no contact is detected at the predetermined distance of the means for characterizing from the shielding element (starting from the surface of the first element), it can be assumed, for example, that this would also be the case if there is a slight tilt, since the second plane at the predetermined distance has caused no contact either.

It should also be mentioned that the first element can be dimensioned, for example, in such a way that it coincides with the mesh structure (or a centre region) of the shielding element.

It should also be mentioned that one aspect of the invention comprises the use of at least one of the means for characterizing according to the second aspect, as a means for characterizing in a method according to the first aspect.

A further aspect relates to the use of a sensor, which is configured to measure a topology, as a means for characterizing in a method according to the first aspect.

A third aspect relates to a particle beam device for irradiating a sample with a particle beam, comprising: a shielding element for shielding an electric field, wherein the shielding element is arranged between a sample position and a particle beam source; a means for characterizing the shielding element according to the second aspect, which is positioned on a side of the shielding element that is facing the sample position. The particle beam device may comprise, for example, a particle beam device for the repair of a lithography mask. For example, the particle beam device may be configured to perform a mask repair (e.g. as part of an automated, semi-automated and/or manual repair process).

The means for characterizing can, for example, be installed permanently or over a longer period of time in the particle beam device. However, the means for characterizing can also be comprised in the particle beam device for a short time or over a defined period of time as part of a characterization of the shielding element (as described herein).

The particle beam source of the particle beam device can, for example, emit a particle beam comprising charged particles (e.g. electrons and/or ions). Furthermore, the particle beam device may be configured to observe the sample via the particle beam (e.g. by means of electrons for recording an electron image). Furthermore, the particle beam device may be configured for a particle beam-induced etching of the sample and/or a particle beam-induced deposition of material on the sample (e.g. as part of a mask repair). For example, the particle beam device can be used for the repair of masks for ELTV lithography, DLTV lithography and/or for the repair of masks for other types of lithography methods.

A fourth aspect relates to a computer program comprising instructions which, when executed by a computer and/or a particle beam device according to the third aspect, cause the computer and/or the particle beam device to carry out a method according to the first aspect.

Alternatively or additionally, the computer program may include instructions for performing the further method steps described herein or for carrying out or implementing the functionalities of the devices (or systems) as described herein. For example, the computer program may cause certain components (or means) of the device (or system) to be controlled in an open loop or a closed loop so that a step of the method and/or a functionality of the device can be (automatically) implemented. The device can thus be controlled in an open and/or closed loop based on a computer program and an interface to the components (or means) of the device.

A fifth aspect relates to a particle beam device for irradiating a sample with a particle beam, wherein the particle beam device comprises the computer program according to the fourth aspect. For example, the particle beam device may comprise a (non-volatile) memory which comprises (or stores) the computer program. The particle beam device of the fifth aspect may, for example, comprise a particle beam device according to the third aspect and a means for characterizing (as described herein).

A further aspect relates to the devices, described herein, having a memory which comprises a computer program for at least partial automated control of the device. Further, the device of an aspect may have a means for executing the computer program. Alternatively, it is also possible for the computer program to be stored elsewhere (e.g. in a cloud) and for the device to merely have means for receiving instructions that arise from executing the program elsewhere. Either way, this may allow, for example, the method to run in automated or autonomous fashion within the system and/or device. Thus, intervention, e.g. by means of a manual measure, can be minimized so that the complexity during the operation of the device (or the system) can be reduced. Furthermore, it is conceivable that a protocol is created when one of the methods described herein is carried out. The protocol may comprise, for example, one of the parameters described herein during the method (e.g. the positions of the means for characterizing, the captured topology, the control signal, etc.). The protocol can then for example enable the performance of the method and also the acquisition of its details (e.g. the positions of the means for characterizing) at a later time (e.g. as part of an error assessment, an audit, a service action, etc.). The protocol can comprise, for example, a protocol file (e.g. a log file), which can be stored, for example, in a device and/or in a computer.

The features (and examples) of the method (or computer program) mentioned herein may also be applied or be applicable correspondingly to the aforementioned devices (or systems). The features (and examples) of the devices (or systems) mentioned herein may also be applied or be applicable correspondingly to the methods (and computer programs) described herein.

### 4. Brief description of the figures

The following detailed description describes technical background information and working examples of the invention with reference to the figures, which show the following:
- **Fig. 1**: illustrates schematically a side view of a particle beam device with a shielding element and a sample in a sample position.
- **Fig. 2**: illustrates schematically a side view of a defect of the shielding element, which extends into the sample.
- **Fig. 3**: illustrates schematically a side view of a first means for characterizing the shielding element.
- **Fig. 4**: illustrates schematically a side view of a second means for characterizing at a predetermined distance from the shielding element, wherein the shielding element has no defect.
- **Fig. 5**: illustrates schematically a side view of the second means for characterizing at the predetermined distance from the shielding element, wherein the shielding element has a defect.
- **Fig. 6**: illustrates schematically a side view of a third means for characterizing at a predetermined distance from the shielding element, wherein the shielding element has no defect.
- **Fig. 7**: illustrates schematically a side view of the third means for characterizing at the predetermined distance from the shielding element, wherein the shielding element has a defect.
- **Fig. 8**: illustrates schematically a plan view of an analysis of a scratch mark on a means for characterizing the shielding element via the particle beam device.

### 5. Detailed description of the figures and possible embodiments

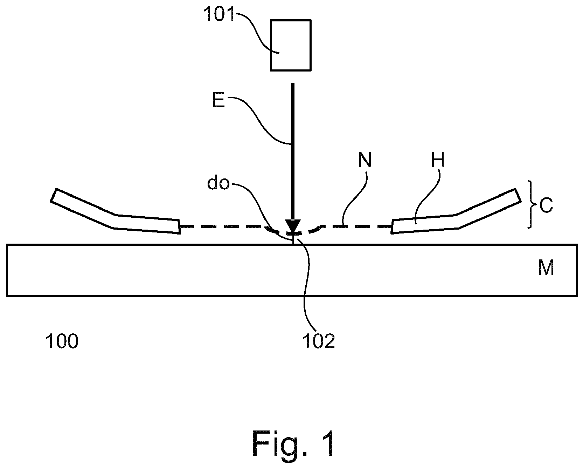

Fig. 1 schematically illustrates a side view of a particle beam device having a shielding element and a sample in a sample position. The particle beam device 100 may comprise a particle beam source 101. The particle beam source 101 can, for example, emit a directed particle beam E. The particle beam E may comprise charged particles (e.g. electrons and/or ions). The particle beam device may further comprise means to control the particle beam E in a targeted manner (e.g. for a targeted deflection, focusing, correction, etc. of the particle beam E). The particle beam E can be directed at a sample M in this case. Fig. 1 illustrates an exemplary sample position of the sample M.

The device 100 may have a shielding element C between the particle beam source 101 and the sample position. The shielding element C can be used to shield an electric field, which can originate from the sample M. The electric field may be caused, for example, by charges that are accumulated on the sample by the irradiation with the particle beam E. For example, the charges introduced cannot always drain away via the sample holder, and so an electric field can emanate from the sample M. By means of the shielding element C, the electric field can be limited to the space between the sample M and the shielding element C. Thus, the particle beam E (or its charged particles) can be shielded from the electric field in the region between the shielding element C and the particle beam source 101. An uncontrolled offset of the particle beam can thus be prevented. The shielding element can be designed, for example, as disclosed in DE102020124307 A1.

The shielding element C may comprise a mesh element N. The mesh element N can comprise one or more openings. For example, the mesh element N may comprise an opening in the form of a single-pinhole stop. For example, the shielding element N may also have one or more openings, e.g. in the form of one or more meshes. An opening in the mesh element N may include any shape (e.g. a round shape, a polygonal shape, a square shape, a hexagonal shape, a honeycomb shape, etc.). An opening in the mesh element N may have a dimension of less than 50 micrometres in at least one direction. It is also conceivable that an opening in the mesh element N has a dimension of less than 30 micrometres, less than 20 micrometres or less than 10 micrometres in at least one direction. Preferably, the dimension of an opening in a mesh element N may lie in a range between 5 µm and 30 µm in at least one direction. Furthermore, the properties of a plurality of openings in the mesh element N may differ from each other (e.g. a first opening may be a round opening with a diameter of 50 µm and a second opening may be a round opening with a diameter of 10 µm).

The material from which the meshes are formed may be electrically conductive in order to enable shielding of the electric field. For example, the material of the mesh element N may comprise at least one of the following: gold, nickel, palladium, platinum, iridium. For example, a thickness of the mesh element N can lie in a range between 1 nm - 100 µm, 10 nm - 100 µm, 100 nm - 50 µm, 1 µm - 30 µm, 5 µm - 15 µm.

The shielding element C may further comprise a holding element H. The mesh element N can be fastened to the holding element H. The holding element H may be wider in at least one spatial dimension compared with the mesh element N. This can enable a stable fastening of the mesh element N to the holding element H.

A through opening 102 can be arranged in the middle of the mesh element N. The properties thereof may correspond to the properties described herein for an opening in the mesh element N. For example, the through opening 102 may comprise a dimension of less than 50 µm in at least one direction. For example, the particle beam E can be aligned such that it is incident on the sample M through the through opening 102. The through opening 102 can comprise a defined mesh (e.g. with a defined opening) here, which is specifically configured to allow passage of the particle beam E. Further, the through opening 102, or the region of the mesh element N in the region of the through opening 102, may be convex curved on the sample side. It is also conceivable that the region of the mesh element N in which the through opening 102 is located is designed in the form of a triangle or a pyramid (wherein, for example, a tip of the triangle or of the pyramid points towards the sample/sample holder). For example, in this case, the through opening 102 may comprise the tip of the triangle or the pyramid.

The mesh element N may have, for example, a diameter of at least 1 mm, at least 2 mm, at least 3 mm, at least 5 mm and/or at least 10 mm. The diameter may be defined from a first side of the holding element H to an opposite side of the holding element H, between which the mesh element N is mounted.

The sample M may be positioned at a predetermined sample distance do from the shielding element C. In the example of Fig. 1, the predetermined sample distance do is defined as the shortest distance between the through opening 102 as the reference point of the shielding element C and the surface of the sample M. However, it is conceivable that any other reference point of the shielding element C is used to define the predetermined sample distance do.

The predetermined sample distance do can correspond to a target distance of the sample M from the shielding element. The target distance do can correspond to a working distance at which the sample is processed. For example, the target distance may be at least 5 µm, at least 10 µm, at least 15 µm, at least 20 µm and/or at least 50 µm. In addition, the target distance can have a defined value, which lies, for example, in the range between 5 µm and 100 µm.

For example, the particle beam device 100 may be configured for a repair of a sample M. When processing the sample, e.g. a particle beam-induced etching and/or deposition can be carried out, and also an observation of the sample with the particle beam.

For example, the particle beam device 100 may comprise a mask repair device. In this case, the sample M may comprise a lithography object. For example, the sample M can comprise a lithographic mask suitable for any lithography method (e.g. EUV lithography, DUV lithography, i-line lithography, nanoimprint lithography, etc.). In one example, the lithographic mask may comprise an EUV mask, a DUV mask, an i-line lithography mask and/or a nanoimprinting stamp. In addition, the lithography object may comprise a binary mask (e.g. a chromium mask, an OMOG mask), a phase mask (e.g. a chromium-free phase mask, an alternating phase mask (e.g. a rim phase mask)), a half-tone phase mask, a tritone phase mask and/or a reticle (for example with pellicle). The lithographic mask may be used, for example, in a lithography method for the production of semiconductor chips.

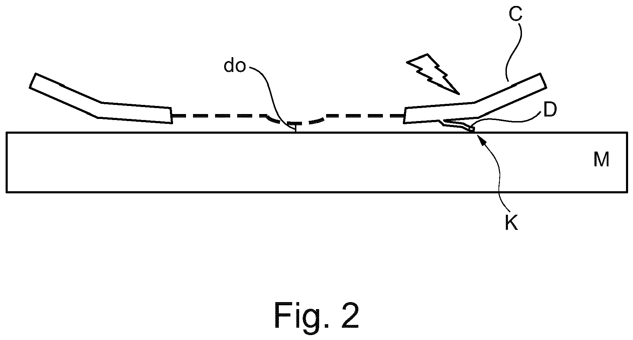

Fig. 2 shows schematically a side view of a defect D of the shielding element, which extends into the sample M. For example, the defect D may be located in a region of the holding element H of the shielding element C on the sample side. The defect D therefore cannot be detected with the particle beam E. The defect D can be caused, for example, by a manufacturing error, a service action and/or a maintenance measure. In Fig. 2, the sample M is positioned at the target distance do from the shielding element C. However, at this working distance, the defect D can contact the sample M. That is to say, in this case there is unwanted contact between the shielding element C and the sample M. The contact may cause a local force to act on the surface of the sample M. This means that a faulty site K can be brought about on the sample M by way of the contact. The faulty site K may include, for example, a scratch mark and/or a local depression. However, in an industrial environment it may be necessary to reliably prevent damage to the sample. For example, this is of great importance in mask repair, as otherwise the faulty site could be transferred lithographically to a wafer. Furthermore, the uncontrolled contact K between the sample M and the shielding element C can damage the shielding element C. Therefore, contact at the target distance of the sample from the shielding element should be avoided. This can be ensured by the characterizing of the shielding element C according to the invention as described herein.

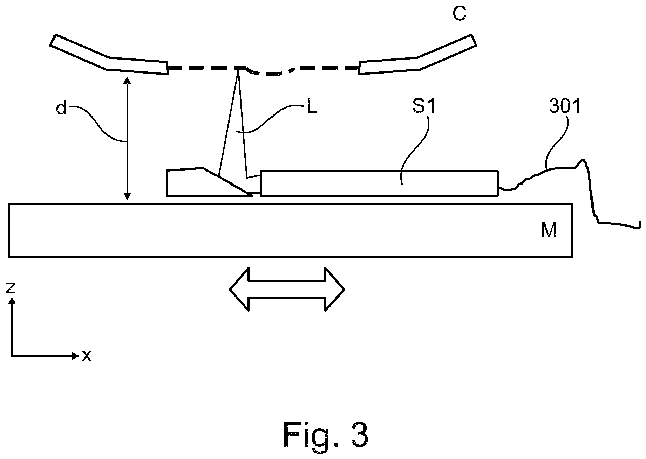

Fig. 3 illustrates schematically a side view of a first means for characterizing the shielding element. The first means may comprise a confocal sensor S1, which can be designed, for example, as a confocal sensor S1. The confocal sensor S1 can be mounted on a sample M. The sample M may comprise an (unstructured) mask blank for a lithographic mask. For example, the confocal sensor S1 can be mounted on the sample M via a bonding means (e.g. via an adhesive, an adhesive layer, etc.). It is also conceivable that the confocal sensor S1 can also rest loosely on the sample M, wherein e.g. the underside of the confocal sensor S1 can be roughened, so that a stable placement of the confocal sensor S1 (e.g. without slipping of the sensor) is ensured. The confocal sensor S1 can be positioned on the side of the shielding element facing the sample position for the purpose of characterization. Defective sites can therefore be reliably detected. Above all, defects on the sample side of the holding element H of the shielding element C can also be detected. The confocal sensor S1 can be positioned via the sample holder on which the sample M with the confocal sensor S1 is mounted. The confocal sensor S1 can generally be configured to be accommodated by the sample holder.

In particular, the confocal sensor S1 can enable a measurement of the topology of the shielding element C on the sample side. The confocal sensor S1 can be used to perform a measurement according to a confocal measurement principle. The confocal sensor S1 can comprise a light source for this purpose, which can focus light L as measurement light on the shielding element C. Furthermore, the confocal sensor S1 may comprise a detector which detects the light reflected at the shielding element C. The detector and the light source can comprise components that are necessary for a confocal measurement principle. For example, the detector may have a pinhole stop for an intermediate image plane in order to enable confocal measurement. Point-by-point scanning of the surface of the shielding element C for the confocal measurement can be carried out, for example, by deflecting the beam of the light L. Furthermore, it is also conceivable that the point-by-point scanning takes place via the positioning of the confocal sensor S1. As indicated in Fig. 1, the confocal sensor S1 can be positioned here at a measurement distance d from the shielding element C on the sample side. Subsequently, the confocal sensor S1 can be displaced along the lateral direction parallel to the surface of the sample in the sample position. The lateral direction is shown here via the x-axis in Fig. 3. Point-by-point scanning of the surface of the shielding element C on the sample side can thus be made possible by the lateral positioning of the confocal sensor S1. The confocal sensor S1 can be communicatively coupled to an external device and/or the particle beam device via a cable 301. For example, it is possible to ensure in this way that the positioning and sensory capture for the confocal measurement are coordinated.

In one example, the confocal sensor S1 is connected to an external device. The external device may be coupled to the particle beam device in such a way that the sample holder of the particle beam device can be controlled accordingly via the external device during the confocal measurement. In another example, only the sample holder is coupled to the external device and can be controlled by the external device for the confocal measurement for the scanning. In another example, the confocal sensor S1 is communicatively coupled to the particle beam device. The sample holder can be controlled here by the particle beam device for the confocal measurement.

Furthermore, it is also conceivable that the first means comprises a sensor other than the confocal sensor S1. For example, an interferometric sensor can also be used, wherein the topology can be captured based accordingly on an interferometric measurement principle. An optical sensor, e.g. a CCD sensor, which can record an optical image of the shielding element, is also conceivable. Furthermore, a combination of different sensors, which are comprised in the first means for characterizing, is also conceivable. For example, a plurality of sensors can be mounted on the sample M for this purpose. For example, a plurality of measurements according to the respective applicable measurement principle might be used.

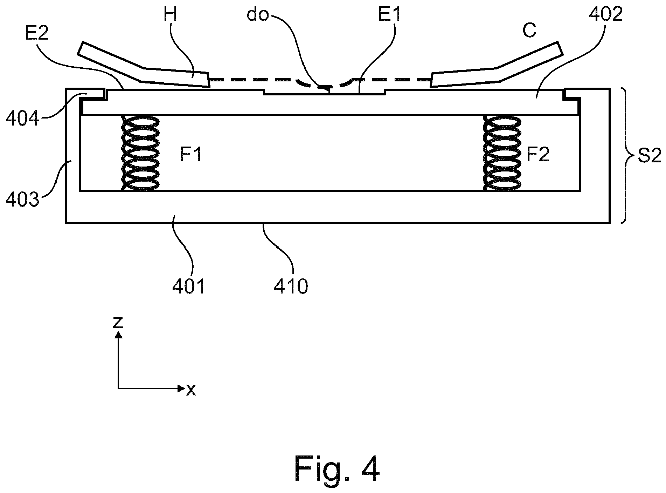

Fig. 4 illustrates schematically a side view of a second means for characterizing at the predetermined distance do from the shielding element, wherein the shielding element C has no defect. The second means may comprise a first microstructure S2. The first microstructure S2 may comprise a base 401. The base 401 may comprise an underside 410, which may lie on a sample holder, for example. The base 401 can be e.g. in the form of a frame structure, as indicated in Fig. 4. The microstructure S2 may comprise a contact surface 402, which is coupled to the base 410 in the vertical direction (along the z-axis of Fig. 4). During the characterizing, the contact surface 402 may in the process come into contact with the shielding element C (as described herein). The contact surface 402 can be coupled to the base 401 in the vertical direction (perpendicular to the underside 410) via a first spring F1 and a second spring F2. If a force is applied on the contact surface in the direction of the underside 410, it can be deflected or moved accordingly in the direction of the underside 410.

The contact surface 402 may comprise in this respect a first plane E1 and a second plane E2. The first plane E1 can be arranged below the second plane E2 (with reference to the underside of the base 401 or the specified z-direction). The first plane E1 can be dimensioned such that it lies opposite a central region of the mesh element N of the shielding element C at a characterizing position of the means for characterizing. The second plane E2 can be dimensioned in such a way that it coincides in the characterization position with a peripheral region of the shielding element C (e.g. with the holding element H and a partial region of the mesh element N). The dimensioning of the planes can therefore be matched with the dimensions of the shielding element.

The first microstructure S2 may further comprise a side structure 403. The side structure 403 can extend perpendicular from the underside 410 of the base 401. The side structure 403 may comprise a formed holding region 404 in the region of the contact surface 402 (as described herein). The holding region 404 can be dimensioned for a positive fit with the contact surface 402. The contact surface 404 can be fixed (in the z-direction) in a defined manner via the holding region 404, since the holding region 404 can spatially limit the movement of the contact surface in the positive z-axis (e.g. a movement in the positive z-axis can be caused by the force of the first spring F1 and/or second spring F2).

The first microstructure S2 can be (at least partially) electrically conductive. Thus, the first microstructure S2 can enable a method (as described herein). For example, the presence or absence of a contact of the first microstructure S2 at a predetermined distance from the shielding element can be detected with the first microstructure. The predetermined distance (e.g. the target distance of a sample during processing of the sample with the particle beam device) can be selected with respect to the first plane E1, for example in order to take into account a tilt and/or a safety margin (as described herein).

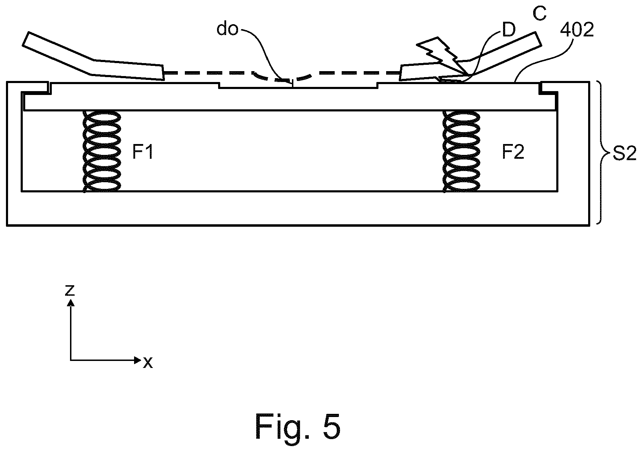

Fig. 5 illustrates schematically a side view of the second means for characterizing at the predetermined distance from the shielding element, wherein the shielding element has a defect D. In this example, the first microstructure S2 was moved closer to the shielding element C in the z-direction. The defect D of the shielding element C contacts the contact surface 402 at the predetermined sample distance do. However, it is also conceivable that the defect D is designed such that the defect D contacts the contact surface 402 even at a greater sample distance than the predetermined sample distance do. As described herein, an electrical current can flow through the shielding element C and the first microstructure S2 due to the contact. For example, the current can flow from the sample holder through the first microstructure S2 via the shielding element C to the particle beam device 100. If a current flows, the presence of a contact or a contact signal can thus be determined. Accordingly, the further approach towards the shielding element C can be aborted. The method may comprise, for example, ascertaining the z-position of the first microstructure S2 in the case of a contact and ascertaining the sample distance accordingly. Thus, for example, it can be determined at what sample distance a real sample would contact the shielding element. Further, the method may comprise realizing a repair and/or assessment of the shielding element C based on the presence of a contact at the predetermined sample distance (or at a greater sample distance).

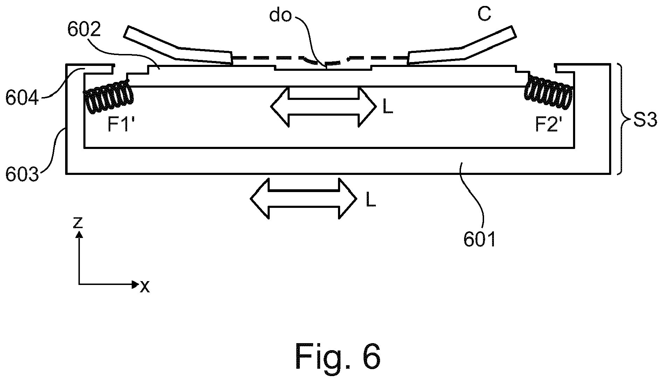

Fig. 6 illustrates schematically a side view of a third means for characterizing at a predetermined distance from the shielding element, wherein the shielding element has no defect. The third means may comprise a second microstructure S3. Similar to the first microstructure S2, the second microstructure S3 may comprise a base 601. For example, the second microstructure S3 may likewise comprise a side structure 603 and a holding region 604. The second microstructure S3 can have a contact surface 602. The contact surface 602 can be movably coupled to the base 601 along a plane of the contact surface 602. In Fig. 6, the contact surface 602 is mounted movably in the x-direction (or in the lateral direction L). The movable mounting can be caused, for example, by at least one spring element. Thus, the second microstructure S3 may comprise a first lateral spring F1' and a second lateral spring F2'. The first lateral spring F'1 can be mounted between a first side of the side structure 603 and a first peripheral region of the contact surface 602. Accordingly, the second lateral spring F2' can be mounted, on the opposite side of the second microstructure S3, between a second side of the side structure and a second peripheral region of the contact surface 602. The contact surface 602 can thus be mounted movably in the lateral direction L via the springs F1' and F2'.

Furthermore, all the features of the first microstructure S2 may be comprised in the microstructure S3 (and vice versa). Thus, for example, it can be seen in Fig. 6 that the contact surface 602 has analogously a first plane and a second plane, just like the first microstructure S2. It should also be noted that the contact surface 602 can also be mounted movably in the z-direction (perpendicular to the underside of the base 601). For example, this can be made possible via a spring system as shown and described in Fig. 5.

In the example in Fig. 6, the contact surface 602 is arranged at the predetermined sample distance do from the shielding element. In this example, the shielding element C initially has no defect or deviation. If the second microstructure S3 in its entirety is moved here from a first position to a second position by a predetermined distance in the x-direction, the contact surface accordingly moves concomitantly. For example, the microstructure S3 in its entirety can be moved with the sample holder. This results in a distance which the base 601 travels and a distance which the contact surface 602 travels. Without any contact between the shielding element C and the contact surface 602, both distances travelled can be the same, since no disturbing force in the x-direction can affect the contact surface 602. This is evident in Fig. 6, since the contact surface 602 is arranged symmetrically with respect to the base. However, in the event of a defect in the shielding element C which extends into the sample position, for example, the contact surface 602 can be influenced. This can be detected in order to characterize the shielding element on the sample side.

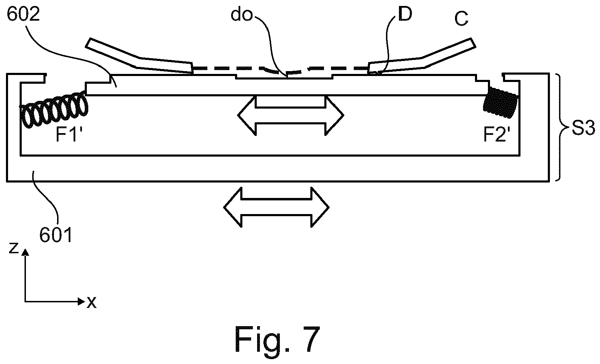

Thus, Fig. 7 illustrates schematically a side view of the third means for characterizing at the predetermined distance from the shielding element, wherein the shielding element has a defect D. The defect D can extend into the sample position and therefore interact with the contact surface 602. The defect D can, for example, counteract the contact surface 602 during the movement in the x-direction. However, due to the springs F1' and F2', the defect D cannot or only minimally counteract the movement of the base 601. The view of Fig. 7 can indicate the second microstructure S3 after a movement by the predetermined distance in the x-direction (or in the lateral direction). It can be seen that the contact surface did not move concomitantly by the same distance as the base 601. Accordingly, the contact surface 602 is no longer arranged symmetrically with respect to the base 601. It is also evident that the second lateral spring F2' can be compressed by the obstruction of the movement of the contact surface 602 in the x-direction. The first lateral spring F1' can be stretched, by contrast.

The difference between the movement distance of the contact surface 602 and the movement distance of the base 601 can be brought about as described herein. For example, the base 601 can be moved by a defined distance from a first position to a second position via the sample holder. The distance the contact surface travels in this process can be tracked, for example, by comparing a particle beam image of the contact surface in the first position with a particle beam image of the contact surface in the second position (as described herein). The particle beam images can be recorded via the particle beam E, wherein, for example, a scanning electron image can be recorded.

Furthermore, the second microstructure S2 may be (at least partially) electrically conductive. Thus, a contact signal based on an electrical current flow through the shielding element C and the second microstructure S2 can likewise be detected (as described herein).

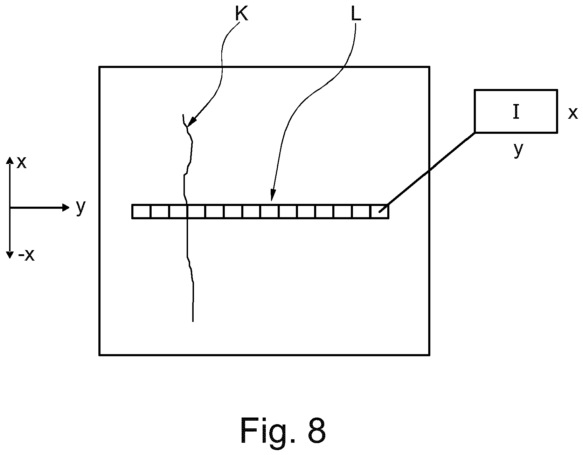

Fig. 8 illustrates schematically a plan view of an analysis of a scratch mark K on a means for characterizing the shielding element C via the particle beam device 100. The analysis of the scratch mark can, for example, be carried out alternatively or in addition to a characterization method with the second means and/or the third means for characterizing (as described herein). An exemplary method may involve first a movement of the means for characterizing such that a scratch mark is generated, if necessary. For example, the means for characterizing can first be positioned at the predetermined sample distance (i.e. the target distance) from the shielding element C. This initial position may be associated with an x-value of zero and a y-value of zero, wherein the x-direction and y-direction may be parallel to the surface of the means for characterizing. Then the means for characterizing can be moved to a first, positive x-position (e.g. to x = + val). The means for characterizing can then be moved to a second, negative x-position, which has e.g. the same absolute value as the first x-position (e.g. x = - val). The absolute value of the first or second x-position can correspond to a length over which the shielding element C extends. For example, the length (and width) of the shielding element C can lie in the range of 1 mm to 10 mm. The means for characterizing can thus be shifted e.g. by ± x in terms of the length (or width) of the shielding element (e.g. by ± 3 mm, ± 4 mm, ± 10 mm in the x-direction). The analysis of the scratch mark K can then be performed perpendicular to the x-direction along the y-axis. The analysis can therefore be carried out perpendicular to the "scratch direction". In particular, the analysis can be carried out in situ via the particle beam device 100 via one or more particle beam images. If a scratch mark K is detected, it can be assumed that there is a contact of the shielding element C with a sample at the predetermined sample distance. Accordingly, the presence of a contact can thus be detected as part of a characterization of the shielding element.

It should be mentioned that, for example, the field of view I of the particle beam device 100 may be smaller than a length dimension of the shielding element C. For example, the field of view I may lie in the micrometre range (e.g. 1 µm x 1 µm, 6 µm x 6 µm, 10 µm x 10 µm, etc.), whereas the length dimension of the shielding element C may lie in the millimetre range (as described herein). In this case, a particle beam image can thus be recorded over the field of view I, but not over the entire length of the possible scratch mark K. A complete recording of the surface which was exposed to the shielding element C during the "scratching process" would require a large number of particle beam images. The surface would have to be recorded in two dimensions in the manner of pixels, which could take a very long time, for example.

However, it can be assumed via the exemplary method that in the event of the presence of a contact the scratch mark extends (substantially) along one direction (e.g. the x-direction). Only the associated position perpendicular to it (e.g. the y-position) is unknown.

Therefore, the method may involve that a line perpendicular to the x-direction (i.e. perpendicular to the possible scratch mark K) is analysed over a plurality of particle beam images. For example, the line may be defined along the y-direction at x = o. Thus, a plurality of particle beam images can be recorded over a length L perpendicular to the scratch direction. If a partial region of the scratch mark is detected in a particle beam image, the scratch mark K can be tracked accordingly via further images, e.g. in the direction of the scratch mark. By moving the means for characterizing in ± x along the length of the shielding element C, it can be ensured that in the event of the presence of a contact causing a scratch mark K, the scratch mark K intersects a y-coordinate in the length region of the shielding element C. Accordingly, the scratch mark K can be found and analysed in a suitable manner even with a limited field of view, via the evaluation of a line in the y-direction. It should also be mentioned that, for example, a scratch-free mask blank can also be introduced into the particle beam device as a means for characterizing.

Subsequently further embodiments of the present disclosure are described:
Embodiment 1: Method for characterizing a shielding element (C) of a particle beam device (100) for shielding an electric field between a sample position and a particle beam source (101), the method comprising:
   positioning a means for characterizing (S1, S2, S3) the shielding element on a side of the shielding element which is facing the sample position.
Embodiment 2: Method according to Embodiment 1, further comprising: characterizing the side of the shielding element (C), which is facing the sample position, at least in part with the means for characterizing (S1, S2, S3).
Embodiment 3: Method according to Embodiment 2, wherein the characterizing comprises capturing a topology of the shielding element (C), wherein the topology is captured on the side of the shielding element which is facing the sample position.
Embodiment 4: Method according to Embodiment 2 or 3, wherein the characterizing comprises determining an anomaly in the topology, at least in part on the basis of a target state of the topology and the captured topology.
Embodiment 5: Method according to any of Embodiments 2 to 4, wherein the characterizing further comprises: determining if the shielding element extends into the sample position.
Embodiment 6: Method according to any of Embodiments 3-5, wherein the means for characterizing comprises a sensor (S1) for measuring the topology, and the capturing of the topology is at least in part based on a measurement of the topology using the sensor.
Embodiment 7: Method according to Embodiment 6, wherein the sensor (S1) comprises a confocal sensor, and the measurement of the topology is at least in part based on a confocal measurement principle.
Embodiment 8: Method according to any of Embodiments 6-7, wherein the sensor (S1) comprises an interferometric sensor, and the measurement of the topology is at least in part based on an interferometric measurement principle.
Embodiment 9: Method according to any of Embodiments 1-8, wherein the means for characterizing (S2, S3) is positioned at a predetermined distance from the shielding element;
   wherein the predetermined distance corresponds to a target distance (do) between a sample and the shielding element.
Embodiment 10: Method according to Embodiment 9, further including detecting a presence or absence of a contact of the means for characterizing with the shielding element.
Embodiment 11: Method according to Embodiment 10, wherein the means for characterizing is at least in part electrically conductive, and the detection comprises a detection of an electrical current that flows through the means for characterizing and the shielding element in the presence of the contact.
Embodiment 12: Method according to any of Embodiments 9-11, further including moving the means for characterizing (S2, S3) in a lateral direction (L) which is parallel to the surface of the sample in the sample position.
Embodiment 13: Method according to Embodiment 12, wherein the means for characterizing (S3) comprises a contact surface (602), which is mounted movably in the lateral direction (L),
   wherein the capturing of the topology further comprises:
      moving the means for characterizing from a first position to a second position by a predetermined distance in the lateral direction;
   ascertaining a distance of the contact surface caused by the movement of the means for characterizing in the lateral direction.
Embodiment 14: Method according to Embodiment 13, furthermore including:
   if the contact surface (602) has shifted by the predetermined distance, detecting an absence of the contact;
   if the contact surface has not shifted by the predetermined distance, detecting a presence of the contact.
Embodiment 15: Method according to any of Embodiments 13-14, wherein the ascertainment of the distance comprises:
   recording a first image of a reference structure of the contact surface in the first position of the means for characterizing;
   recording a second image of the reference structure of the contact surface in the second position of the means for characterizing;
   determining a distance between the reference structure in the first image and the reference structure in the second image to ascertain the distance of the contact surface.
Embodiment 16: Method according to any of Embodiments 11-15, further including: detecting a scratch mark (K) on the means for characterizing caused by the movement in the lateral direction (L).
Embodiment 17: Means for characterizing a shielding element (C) of a particle beam device, wherein the shielding element is arranged for shielding an electric field between a sample position and a particle beam source (101), the means comprising:
   a sensor for capturing a topology of the shielding element and/or a movable,
   preferably spring-loaded, contact surface (402, 602) for contacting the shielding element;
   wherein the means is configured to be mounted on a sample holder of the particle beam device.
Embodiment 18: Means for characterizing according to Embodiment 17, further comprising:
   a base (401, 601),
   wherein the contact surface (402, 602) is movably coupled to the base perpendicular to the contact surface, preferably via a spring element.
Embodiment 19: Means for characterizing according to Embodiment 17 or 18, wherein the contact surface (602) is movably coupled to the base (601) along a plane of the contact surface (602), preferably via a spring element.
Embodiment 20: Means for characterizing according to any of Embodiments 17-19,
   wherein the contact surface (402, 602) has a first plane (E1) and a second plane (E2) with reference to the base (401, 601);
   wherein the first plane lies below the second plane;
   wherein the second plane is dimensioned such that it coincides with a peripheral region of the shielding element.
Embodiment 21: Particle beam device for irradiating a sample with a particle beam, comprising:
   a shielding element (C) for shielding an electric field, wherein the shielding element is arranged between a sample position and a particle beam source (101);
   a means for characterizing the shielding element according to any of Embodiments 17-20, which is positioned on a side of the shielding element which is facing the sample position.
Embodiment 22: Particle beam device according to Embodiment 21, wherein the particle beam device is designed for the repair of a lithography mask.
Embodiment 23: Computer program comprising instructions which, when executed by a computer and/or a particle beam device according to Embodiment 21 or 22, cause the computer and/or the particle beam device to carry out a method according to any of Embodiments 1-16.
Embodiment 24: Particle beam device for irradiating a sample with a particle beam,
   wherein the particle beam device comprises the computer program according to Embodiment 23.

## Claims

1. Method for characterizing a shielding element (C) of a particle beam device (100) for shielding an electric field between a sample position and a particle beam source (101), the method comprising:
positioning a means for characterizing (S1, S2, S3) the shielding element on a side of the shielding element which is facing the sample position.

2. Method according to claim 1, further comprising:
characterizing the side of the shielding element (C), which is facing the sample position, at least in part with the means for characterizing (S1, S2, S3).

3. Method according to claim 2, wherein the characterizing comprises capturing a topology of the shielding element (C), wherein the topology is captured on the side of the shielding element which is facing the sample position.

4. Method according to claim 2 or 3, wherein the characterizing comprises determining an anomaly in the topology, at least in part on the basis of a target state of the topology and the captured topology.

5. Method according to any of claims 2 to 4, wherein the characterizing further comprises: determining if the shielding element extends into the sample position.

6. Method according to any of claims 3-5, wherein the means for characterizing comprises a sensor for measuring the topology, and the capturing of the topology is at least in part based on a measurement of the topology using the sensor.

7. Method according to any of claims 1-6, wherein the means for characterizing (S2, S3) is positioned at a predetermined distance from the shielding element; wherein the predetermined distance corresponds to a target distance (do) between a sample and the shielding element.

8. Method according to claim 7, further including detecting a presence or absence of a contact of the means for characterizing with the shielding element.

9. Method according to claim 8, wherein the means for characterizing is at least in part electrically conductive, and the detection comprises a detection of an electrical current that flows through the means for characterizing and the shielding element in the presence of the contact.

10. Method according to any of claims 7-9, referred back to claim 3, wherein the means for characterizing (S3) comprises a contact surface (602), which is mounted movably in the lateral direction (L),
wherein the capturing of the topology further comprises:
moving the means for characterizing from a first position to a second position by a predetermined distance in a lateral direction (L) which is parallel to the surface of the sample in the sample position;
ascertaining a distance of the contact surface caused by the movement of the means for **characterizing in** the lateral direction.

11. Method according to claim 10, furthermore including:
if the contact surface (602) has shifted by the predetermined distance, detecting an absence of the contact;
if the contact surface has not shifted by the predetermined distance, detecting a presence of the contact.

12. Method according to any of claims 7-11, further including:
moving the means for characterizing (S2, S3) in a lateral direction (L) which is parallel to the surface of the sample in the sample position;
detecting a scratch mark (K) on the means for characterizing caused by the movement in the lateral direction (L).

13. Means for characterizing a shielding element (C) of a particle beam device,
wherein the shielding element is arranged for shielding an electric field between a sample position and a particle beam source (101), the means comprising:
a sensor for capturing a topology of the shielding element and/or a movable, preferably spring-loaded, contact surface (402, 602) for contacting the shielding element;
wherein the means is configured to be mounted on a sample holder of the particle beam device.

14. Particle beam device for irradiating a sample with a particle beam, comprising:
a shielding element (C) for shielding an electric field, wherein the shielding element is arranged between a sample position and a particle beam source (101);
a means for characterizing the shielding element according to claim 13, which is positioned on a side of the shielding element which is facing the sample position.

15. Computer program comprising instructions which, when executed by a computer and/or a particle beam device according to claim 14, cause the computer and/or the particle beam device to carry out a method according to any of claims 1-12.
